# EUROPEAN PATENT SPECIFICATION

(11) **EP 2 785 898 B1**
(45) Date of publication and mention of the grant of the patent: **13.09.2017**
(21) Application number: 12795843.7
(22) Date of filing: 03.12.2012
(51) Int. Cl.: B28D 5/04, C30B 11/00, C30B 11/02, C30B 15/00, H01L 31/0312, H01L 31/036, C30B 11/14, C30B 29/06

(54) **PRODUCTION OF MONO-CRYSTALLINE SILICON**
HERSTELLUNG VON MONOKRISTALLINEM SILICIUM
PRODUCTION DE SILICIUM MONOCRISTALLIN

(30) Priority: 01.12.2011 GB 201120696; 01.12.2011 US 201161565611 P
(43) Date of publication of application: 08.10.2014
(73) Proprietor: REC Wafer Pte. Ltd., Singapore 637312 (SG)
(72) Inventor: SAUAR, Erik, N-0372 Oslo (NO); FEFELOV, Oleg, N-3925 Porsgrunn (NO); CARNEL, Lode, N-3944 Porsgrunn (NO)
(74) Representative: Gill Jennings & Every LLP
(86) International application number: PCT/GB2012/052985
(87) International publication number: WO 2013/079976

(56) References cited:
- WO-A2-2007/084936
- DE-A1-102010 029 741
- TAKAHASHI I ET AL: "Generation mechanism of dislocations during directional solidification of multicrystalline silicon using artificially designed seed", JOURNAL OF CRYSTAL GROWTH, ELSEVIER, AMSTERDAM, NL, vol. 312, no. 7, 15 March 2010 (2010-03-15), pages 897-901, XP026929260, ISSN: 0022-0248, DOI: 10.1016/J.JCRYSGRO.2010.01.011 [retrieved on 2010-01-18]

## Description

### Field of the invention

The present invention relates to the production of crystalline silicon for use in solar cells. In particular, the present invention relates to the production of crystalline silicon by directional solidification processes.

### Background to the Invention

The majority of silicon wafers for use in photovoltaic cells are produced using directional solidification processes such as the Bridgman method. In such processes, solid silicon feedstock is introduced into a crucible and is subsequently melted to form molten silicon. To obtain crystalline silicon, the molten silicon is then gradually solidified in a directional process which allows the crystalline structure to form in a solid silicon ingot.

The silicon formed in conventional directional solidification processes is typically multi-crystalline silicon. As such, the silicon has a complex structure comprising a plurality of crystalline grain formations. The grain boundaries and resulting dislocations in the material typically lead to a reduced performance. As a consequence, photovoltaic cells formed of mono-crystalline silicon are found to offer better performance than photovoltaic cells formed of multi-crystalline silicon.

The possibility of creating low cost mono-crystalline silicon wafers has therefore been investigated. One process for the formation of mono-crystalline silicon is known as the Czochralski process. In this process, mono-crystalline silicon is formed on an elongated seed crystal which is gradually removed from a crucible of molten silicon while simultaneously being rotated. The result is a cylindrical rod of mono-crystalline silicon. This can then be cut to form wafers for use in photovoltaic cells.

Photovoltaic cells comprising mono-crystalline silicon formed by the Czochralski process can offer improved efficiency as compared to photovoltaic cells formed of multi-crystalline material formed by directional solidification processes. These advantages arise primarily because of the inherent properties of the crystalline silicon, but also because of their suitability for later processing steps. For example, it is common that an etching or texturing step is applied to the surface of a silicon wafer in order to increase its light-absorbing properties.

In particular, a particular wet-etching process has been developed for use with mono-crystalline silicon. In this process, an alkaline solution, such as potassium hydroxide (KOH), is applied to a {100} surface of the mono-crystalline silicon wafer. This results in a surface which comprises a regular array of micro-pyramids. This regular pattern has been found to show good light absorption properties.

The mechanism by which the wet-etching process described above operates is based on the anisotropic effects of the alkaline solution on the wafer. This means that the different crystallographic planes of the wafer at etched at different rates by the solution, resulting in the regular pyramidal surface mentioned above. In order to create this structure, the surface of the wafer must be parallel to the {100} crystallographic plane.

The anisotropic etching process described above is not suitable for a multi-crystalline wafer, which displays no consistency in the orientation of the crystalline structure. As a result, isotropic etching processes are typically applied to multi-crystalline wafers. These tend to create an irregular surface texture, which is less efficient in terms of light absorption than the regular pyramidal structure available with anisotropic etching.

So, there are clear benefits to the mono-crystalline wafers produced by the Czochralski process. However, the production of large volumes of wafers for use in photovoltaic cells by this process is found to be relatively expensive as the volume of crystalline silicon that can be produced in a single run of the process is relatively small in practice. In contrast, the crucibles used in directional solidification processes are able to handle a significantly larger amount of silicon in each run.

As a result, multi-crystalline silicon produced by directional solidification processes is substantially cheaper than mono-crystalline silicon produced by the Czochralski process. There has therefore been an ongoing desire to combine the performance benefits of mono-crystalline silicon with the economic benefits of directional solidification processes.

In recent years, progress in this regard has been made with the use of mono-crystalline seed material in directional solidification processes. In one example of such a technique, a mono-crystalline silicon seed material is placed at the bottom of the crucible before the general silicon feedstock is introduced. The silicon feedstock is then melted before being gradually solidified, starting from the only partially melted mono-crystalline seed material. The mono-crystalline seed material acts as the foundations of the crystalline structure in the silicon ingot. In this way, the silicon ingot that is formed comprises at least one substantially mono-crystalline region. As mentioned above, this produces important performance benefits when the silicon formed in this way is used for its ultimate purpose, such as for photovoltaic cells.

Silicon wafers are formed from horizontal slices through the silicon ingot. To ensure that these present a {100} crystalline surface as required for the anisotropic etching process, the seed material is provided such that the {100} plane is perpendicular to the vertical direction of crystal growth during solidification.

Although the use of a seed material in directional solidification processes has been found to offer some success in the growth of mono-crystalline material, it is not completely effective or attractive. In particular, it is found that as the solidification process progresses, the proportion of mono-crystalline silicon formed decreases. In particular, a multi-crystalline region extends from the outer walls of the crucible progressively further towards the centre of the ingot. The result is that the final ingot contains a central mono-crystalline region surrounded by a multi-crystalline region, the width of the multi-crystalline region increasing further up the ingot.

In practice, it is found that the angle between the mono-crystalline region and the seed material, or the bottom of the crucible, frequently is as little as 45-65 degrees. Thus, wafers cut from the ingot contain a significant proportion of multi-crystalline material. This multi-crystalline material is inherently less efficient when used for its purpose in photovoltaic cells and, moreover, is inappropriate for the anisotropic etching process described above. As well as limiting the light absorbing efficiency of the wafers, this latter point also leads to a major undesirable visual difference between etched regions in the wafer that are formed of mono-crystalline material and those that are formed of multi-crystalline material. This very visible inhomogeneity means that it is difficult for manufacturers of solar modules to use such wafers in a module which is visually attractive to customers and thus commercially viable.

Another disadvantage of the incursion of multi-crystalline regions into the ingot comes in the formation of the silicon wafers from the ingot. In particular, it has been proposed to cut the ingot using a wire, and in particular multi-wire sawing technique. The wires used in such techniques may be provided with diamond particles. In the right circumstances, such techniques can provide a high throughput of cut wafers.. However, the grain boundaries, defects and dislocations of the multi-crystalline silicon frequently allow impurities such as silicon carbide to become embedded in the ingot. Such impurities not only decrease the efficiency of the material further, but are also relatively hard, and can break the diamond wire during cutting. As a result, the multi-crystalline regions can cause less optimal cutting processes to be required. This problem is particularly acute when forming ingots using a mono-crystalline seed. This is because the increased time necessary in the process to carefully control the melting of the silicon feedstock without fully melting the seed material offers an increased risk of contamination of the molten material by carbon.

Attempts have been made to mitigate the difficulties described above. For example, it has been proposed that the seed material may be provided on the side walls of the crucible as well as on the crucible floor, as described in US patent 8,048,221. This is intended to seed the mono-crystalline structure from the side walls, avoiding the growth of multi-crystalline silicon at the sides of the ingot. However, it is extremely difficult to control a process of this kind. For example, given that, prior to solidification, molten silicon is provided in the crucible all the way down the seed material placed on the crucible floor, it is difficult to ensure that the seed material on the side walls does not melt. Melting of the seed material renders it ineffective since its crystalline structure is lost. Another approach that has been suggested involves managing the temperature distribution within the crucible more closely in an effort to ensure that a higher proportion of crystal growth originates from the seed material. For example, potential control mechanisms might include intensified cooling of the centre of the crucible and exaggerated heating of the side walls of the crucible. However, in practice such processes suffer from numerous disadvantages, such as increased stress in the ingot which will make it more likely to crack. Moreover, the heat added to the side walls of the crucible represents a cost in terms of energy use and is difficult to implement without melting the seed material. Furthermore, implementation of these processes will slow down crystal growth and productivity.

There is therefore an ongoing need to improve methods for the production of mono-crystalline silicon for use in photovoltaic cells. In particular, while current techniques offer either high quality or low cost silicon wafers, there is a desire to improve both these aspects simultaneously.

### Summary of the invention

According to a first aspect of the present invention, there is provided a method for producing crystalline silicon wafers for use in photovoltaic cells, the method comprising:
providing a silicon seed layer of uniform crystalline orientation in all axes in a crucible;
providing silicon feedstock above the seed layer;
melting the silicon feedstock and an upper part of the seed layer, thereby creating molten silicon within the crucible;
directionally solidifying the molten silicon to form a silicon ingot; wherein
the seed layer is arranged such that solidification of the molten silicon occurs in a direction normal to a {110} crystallographic plane of the seed layer.

According to the present invention, a directional solidification method may be provided to create a silicon ingot having a substantial proportion of mono-crystalline silicon. It is found that by using a seed layer which is arranged such that its {110} crystallographic plane is normal to the direction of solidification, the proportion of mono-crystalline silicon within the resulting ingot is substantially increased, particularly compared to existing systems in which the {100} plane is normal to the direction of growth. It is also found that the density of dislocations that arise using growth in the <110> direction in accordance with the present invention is significantly less than that the dislocation density when growth in the <100> direction is carried out. The orientation of the crystallographic structure of the seed layer is uniform in all axes, thereby ensuring that the growth seeded by that layer is mono-crystalline in nature.

The benefits of orientating the crystallographic structure of the seed layer in this way are found to outweigh the disadvantage that horizontal slices of the ingot are no longer optimised for anisotropic etching. Indeed, the method may further comprise forming one or more silicon wafers from the silicon ingot and, moreover, in preferred embodiments, the method may also comprise applying an isotropic etching process to the silicon wafers. Preferably, the etching process comprises applying an acid to the surface of the silicon, and in preferred embodiments the acid may contain hydrofluoric acid (HF) and/or nitric acid (HNO3). Alternatively, the acid may comprise sulphuric acid (H2SO4). In other preferred embodiments, the etching process may comprise a reactive ion etching process and/or plasma etching process.

The use of an isotropic etching process means that no distinction is made between the mono-crystalline region of the wafers and any remaining multi-crystalline regions. This provides a more effective etching process for a mixed wafer in terms of operational efficiency in use in a photovoltaic cell and visual appearance. Moreover, in preferred embodiments, the one or more wafers are substantially planar parallel to the {110} plane. This allows best use of the wafer material provided in the ingot. Since the wafers therefore present a {110} surface, isotropic methods are more appropriate than anisotropic methods suitable for {100} surfaces. Anisotropic etching processes have conventionally been considered to offer performance benefits over isotropic methods. However, it has been found that in this context the benefits of the method of the present invention outweigh the supposed benefits of anisotropic methods, particularly when the wafers are encapsulated in a module in a photovoltaic cell.

Nevertheless, in alternative embodiments, the ingot may be cut into silicon wafers having a surface parallel to the {100} crystalline plane. In these circumstances anisotropic etching methods, such as those using KOH can be used.

In preferred embodiments, the process of forming the silicon wafers comprises a wire cutting process, preferably a diamond wire cutting process. Such processes are efficient and cost-effective when forming the wafers, and find particular utility in the context of the present invention due to the reduced risk of silicon carbide impurities as compared to the prior art based on the <100> crystal orientation. Silicon carbide impurities are relatively hard and can damage the wires use for wire cutting processes.

As the silicon ingot is formed, a mono-crystalline region is created above the seed layer, while a multi-crystalline material may be formed adjacent to the crucible walls. In preferred embodiments of the present invention, an angle between outer edges of the mono-crystalline region and the seed layer is at least 80 degrees, more preferably at least 85 degrees. This is a significant increase in comparison with prior art techniques in which growth occurs normal to a {100} crystalline surface of a seed layer.

In typical arrangements, a solid-liquid interface travels vertically upwards during solidification. That is to say, the direction of solidification is vertical. Accordingly to ensure that the {110} crystallographic plane of the seed layer is normal to the direction of solidification, this plane is disposed substantially horizontally. Thus, to arrange the seed layer such that solidification of the molten silicon occurs in a direction normal to a {110} crystallographic plane of the seed layer, in preferred embodiments the {110} crystallographic plane is preferably arranged parallel to the crucible floor. In practice, the {110} crystallographic plane of the seed layer may not be perfectly aligned with the crucible floor. However, preferably an angle between the {110} crystallographic plane of the seed layer and a floor of crucible is less than 15 degrees, more preferably less than 10 degrees and most preferably less than 5 degrees. The benefits of the invention are apparent even with such minor deviations from perfect alignment.

Indeed, according to preferred embodiments of the present invention, at least 80%, more preferably 90%, of the silicon ingot formed above the seed layer has a crystalline structure aligned with the crystalline structure of the seed layer. As a result, at least these percentages of the silicon ingot may be formed of mono-crystalline material. The mono-crystalline silicon within the ingot may comprise one or more distinct areas of mono-crystalline silicon. For example, the seed layer may comprise a plurality of seed tiles, in which case a distinct area of mono-crystalline silicon may be grown above each seed tile, each area still sometimes being separated by one or a small set of grain boundaries. However, despite this separation, the overall ingot retains its mono-crystalline (rather than multi-crystalline) nature because the orientation of the crystalline structure is the same in each area.

A proportion of the silicon ingot may not be formed above the seed layer. For example, typically a peripheral region of the silicon ingot adjacent to the crucible walls will comprise multi-crystalline silicon. This is a region that is not formed above the seed layer. For example, a gap may be provided between the crucible walls and the seed layer in a preferred embodiment, and as a result mono-crystalline material does not form in the region above this gap. The gap, and thus the peripheral region, is typically 2-3cm in width.

In preferred embodiments, the seed layer comprises a plurality of silicon tiles. This allows the mono-crystalline seed layer to be formed using conventional techniques, such as the Czochralski process. Preferably, the method further comprises providing a silicon slab, on which the seed tiles are disposed. It has been found that using a silicon slab in this manner can allow improved alignment of the seed tiles in the seed layer. In particular, the silicon slab can avoid misalignment of the seed tiles due to inconsistencies in the crucible floor. These include both imperfections in the crucible floor that present a non-planar surface initially, and non-linear expansion effects of the crucible floor that may occur under the heat of crystallisation process. A wafer obtainable by the method according to the invention offers good performance in a photovoltaic cell as it will contain a relatively large proportion or even 100% of mono-crystalline silicon.

According to a second aspect of the present invention, there is provided a loaded crucible for use in the production of crystalline silicon by directional solidification, the loaded crucible comprising: a silicon seed layer of uniform crystalline alignment in all axes and silicon feedstock disposed above the seed layer, wherein a {110} plane of a crystalline structure of the seed layer extends horizontally. The crucible of the third aspect can be used to produce crystalline silicon through directional solidification in a vertical direction which includes a higher proportion of mono-crystalline silicon than previously possible. Preferred features of the first aspect may be applied equally to the second aspect.

### Brief description of the figures

A preferred embodiment of the present invention will now be described with reference to the accompanying figures, in which:
Figure 1 shows a cross section through a crucible and furnace for use with the preferred embodiment of the present invention;
Figure 2A shows a mono-crystalline silicon source obtained using the Czochralski process;
Figure 2B shows the mono-crystalline silicon source of Figure 2A after the after processing to form a cuboid shape;
Figure 2C shows a plurality of mono-crystalline seed tiles formed from the mono-crystalline source of Figures 2A and 2B;
Figure 3 illustrates the crystallographic alignment of the seed layer for use in accordance with the present invention;
Figure 4A shows the growth of silicon ingot in accordance with a prior art method;
Figure 4B shows the growth of a silicon ingot in accordance with the method of the present invention;
Figure 5 shows the division of a silicon ingot into a plurality of wafers;
Figure 6A shows a silicon wafer formed by a method of the prior art with alkaline texture and anti-reflective coating. and
Figure 6B shows a silicon wafer formed by a method according to the present invention with acid texture and anti-reflective coating.

### Detailed description

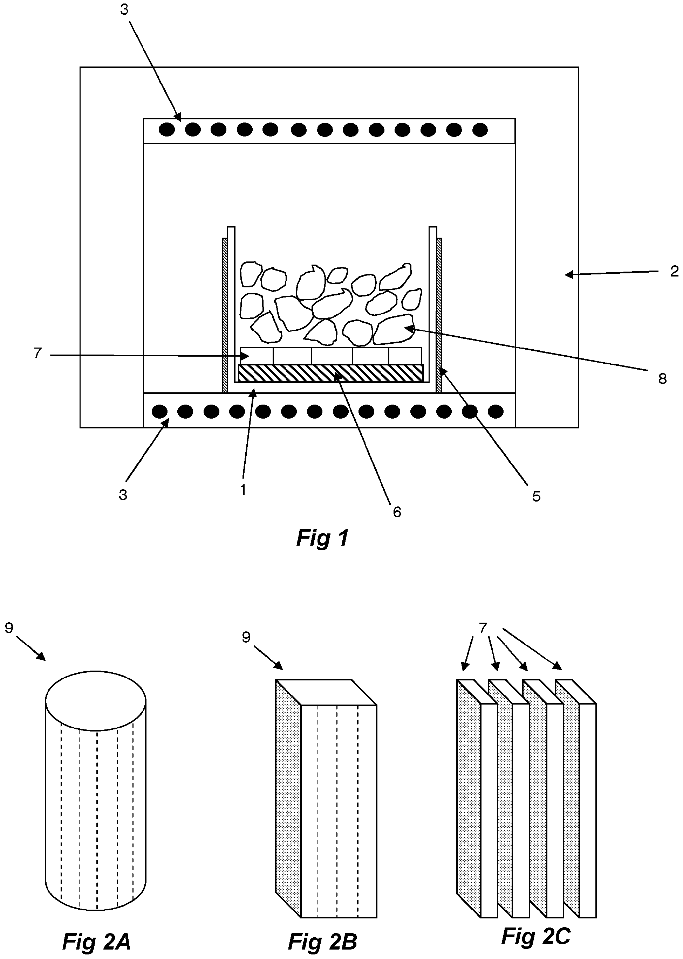

Referring to Figure 1, there is provided a crucible 1 within a furnace hot zone 2. The walls of the furnace hot zone 2 may be formed of graphite or a similar material capable of withstanding high temperatures. In the preferred embodiment, the furnace hot zone 2 shown in Figure 1 is one of a plurality of hot zones within a multi-ingot furnace. Each hot zone 2 may be substantially similar to that shown in Figure 1.

The embodiment of Figure 1 is suitable for use in a directional solidification process for the production of crystalline silicon. Such directional solidification processes include the Bridgman method and Vertical Gradient Freeze methods. The crucible 1 is preferably formed of silica coated with a coating of silicon nitride. The coating assists in ensuring that solid silicon does not stick to the crucible walls during the crystallisation process and in the removal of crystalline silicon from the crucible after the crystallisation process has been carried out. In order to support the structure of the crucible 1 during the crystallisation process, support plates 5 may be provided adjacent to the crucible. The support plates 5 of the preferred embodiment are formed of graphite or silicon carbide coated graphite. Alternatively, the plates 5 may be formed of another chemically inert material with respect to silicon dioxide, such as silicon nitride.

The preferred embodiment of the present invention further comprises heaters 3 disposed above and below the crucible 1. In the preferred embodiment, the heaters 3 are resistive heaters which dissipate power in the form of heat as an electric current is passed through them. The heaters 3 may be formed of graphite. The heaters 3 should be capable of producing the required temperatures for the production of crystalline silicon, which can be up to 1600 degrees Celsius in the top of the furnace.

The crucible 1 of the preferred embodiment shown in Figure 1 is loaded with a single silicon slab 6, a seed layer formed of mono-crystalline silicon tiles 7 and silicon feedstock 8. The silicon tiles 7 are placed upon the silicon slab 6, while the silicon feedstock 8 is disposed above the silicon tiles 7. The crystalline structures of each of the silicon tiles 7 are aligned so that they form a seed layer of uniform crystalline orientation.

The silicon slab 6 is preferably substantially planar, and in the preferred embodiment is substantially planar multi-crystalline silicon. In particular, the silicon slab 6 may be obtained using a directional solidification process which provides a multi-crystalline ingot. The multi-crystalline ingot can then be cut to form the silicon slab 6. A band saw may be used for this cutting step.

The silicon slab 6 will typically have a thickness of between 1 and 3 cm and will cover substantially but not all of the entire floor of the crucible 1. Alternative thicknesses may be used for the silicon slab 6 if required, such as thicknesses between 0.2 cm and 10cm. In one preferred embodiment, the silicon slab 6 measures approximately 63cm by 63cm, compared to a crucible floor size of 68cm by 68cm.

The silicon slab 6 is preferably slightly smaller than the size of the crucible floor. For example, gaps of at least 0.5cm may be provided between the silicon slab 6 and the walls of the crucible 1. This can allow for shrinkage of the crucible 1 during the production process. Without such gaps, the crucible walls 1 are liable to crack during the production process. Typical gaps between the silicon slab 6 and the crucible walls may be 1cm or 2cm, but the gaps may be larger if required. Similar gaps are also formed between the silicon tiles 7 and the side walls of the crucible 1.

The silicon slab 6 presents a flat upper surface to receive the seed layer formed of silicon tiles 7. The silicon slab is large enough to support the alignment of all the silicon tiles 7. For example, the area of the silicon tiles 7 may be the same as the area of the silicon slab 6. However, there may also be variations, and the area of the silicon slab 6 may be larger or slightly smaller than that of the silicon tiles 7.

In the preferred embodiment, the silicon tiles 7 are all cut from the same mono-crystalline source 9, and in particular are all cut from a mono-crystalline source 9 created by the Czochralski process. Because the silicon tiles 7 are all cut from the same source, their crystallisation structures can be accurately aligned when they are placed on the silicon slab 6. In particular, each time a different source 9 is formed it is likely that the relative alignment of the crystalline structure and the physical structure will differ slightly. Thus, if silicon tiles 7 are cut from different sources it is difficult to ensure that the crystalline structure within the tiles is fully aligned. It is therefore an advantage that all silicon tiles 7 are formed from the same source 9.

Notwithstanding the above, it may be that an individual source does not offer sufficient material to form a seed layer across the desired proportion of the crucible 1. In such circumstances, it is preferable to form the silicon tiles 7 from as few sources 9 as possible.

An exemplary mono-crystalline source 9 obtained via the Czochralski process is shown in Figure 2A. As can be seen from this Figure, the mono-crystalline source 9 has a cylindrical profile. The tiles 7 are created by cutting along parallel longitudinal planes through the source 9 (such as along the dashed lines in Figure 2A). Typically, this step is preceded by cutting the curved edges from the cylinder to form a wholly or partially cuboid structure, such as that shown in Figure 2B. The cuboid structure is then cut longitudinally to form the tiles 7, as illustrated in Figure 2C. In the preferred embodiment, the source has a height or major axis equal to or exceeding the desired length of the seed layer within the crucible 1. Accordingly, by cutting longitudinally through the source 1, a single silicon tile 7 can extend across the necessary distance of a desired dimension of the crucible 1.

The silicon tiles 7 are arranged such that a {110} plane of the crystallographic structure lies horizontally across the crucible. As such, the {110} plane is normal to the direction of growth of crystalline silicon during the directional solidification process. That is to say, growth occurs in the <110> direction. In practice, this means that a solid-liquid interface travels in the <110> direction during the process of solidification. This has been found to increase the rate of crystal growth in this direction, which can increase the proportion of crystalline silicon that is formed with a mono-crystalline structure, as will be described in more detail below.

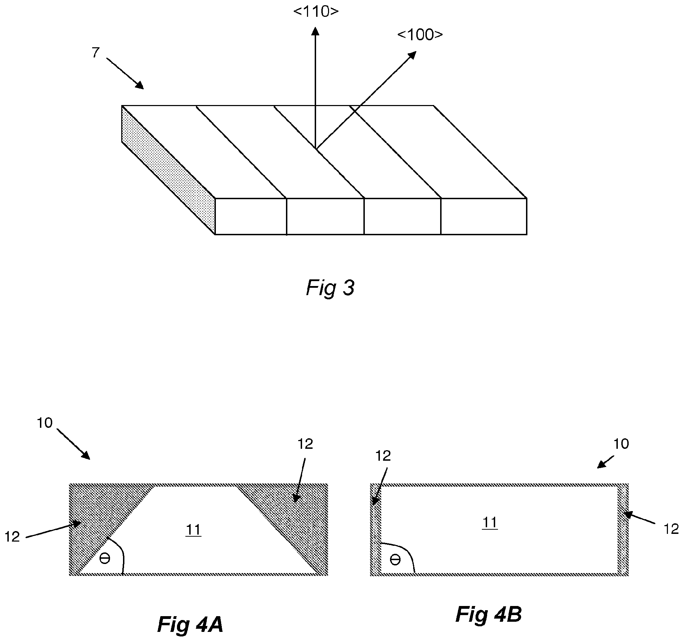

Figure 3 illustrates the seed layer of silicon seed tiles 7, with the directions <110> normal to the plane {110} and the direction <100> normal to the plane {100}. As shown, upper surface of the tiles is co-planar with the plane {110}, while the plane {100} lies at an angle to this surface.

The silicon feedstock 8 of the preferred embodiments comprises a plurality of silicon pieces. These may include silicon chunks obtained through processes such as the Siemens process, recycled silicon chunks from previous directional solidification processes, granular silicon formed through fluidised bed reactor processes, or silicon from any other appropriate source. A mixture of silicon from various sources may be used as appropriate.

So, in use, the preferred embodiment of the present invention is operated as follows. Firstly, the crucible 1 is loaded with the silicon slab 6, the silicon tiles 7 and the silicon feedstock 8 and provided in the furnace hot zone 2.

The heaters 3 are activated to begin a melting stage for the contents of the crucible 1. This melting stage comprises heating the hot zone 2 to a suitable temperature. The melting stage is controlled such that melting of the contents starts with those contents at the top of the crucible 1. This means that the first content of the crucible 1 to melt is the silicon feedstock 8. As the melting stage continues, a solid-liquid interface travels downwardly through silicon feedstock 8 towards the silicon tiles 7.

The position and alignment of the silicon tiles 7 relative to each other is further maintained because the silicon slab 6 upon which they are mounted behaves predictably in the high ambient temperatures. In particular, whereas the silica crucible 1 is found to expand in a non-linear manner and different from silicon when heated, any expansion of the silicon slab 6 is substantially matched by that of the silicon tiles 7 in such conditions. As such, the silicon slab 6 provides a platform for the silicon tiles 7 which allow them to retain the closely-packed and aligned formation given to them when loaded into the crucible 1.

The process of melting the content of the crucible 1 is allowed to continue until a small amount of the surface of the silicon tiles 7 has melted, at which point a process of directional solidification begins. It is desired that the amount of silicon tiles 7 that is melted is limited in order to minimize risk of melt-through and to ensure that they can be re-used a maximum number of times in further processes, as will be explained in greater detail below. However, at least a part of the silicon tiles 7 must melt to allow them to act as a seed material during the directional solidification process.

As the silicon tiles 7 of the seed layer are packed closely together with aligned crystalline structure, they act as a mono-crystalline seed during the directional solidification process.

Initiating the directional solidification process comprises controlling the heaters 3 to stop the melting process and to allow the molten material in the crucible 1 to gradually solidify from the seed layer upwards. Typically, the process is initiated by a trained operator who is monitoring the system, but it may be that automatic control of the initiation may be appropriate in some circumstances.

During the directional solidification process, the direction of movement of the solid-liquid interface is reversed as compared to its progress during the earlier melting process. As the solidification occurs, crystalline structure forms in the material, the crystalline structure being aligned with that in the seed layer of silicon tiles 7. Accordingly, the {110} plane of the seed tiles 7 is maintained in the mono-crystalline silicon which grows from the seed tiles 7. As a result, a silicon ingot 10 formed substantially or predominantly of mono-crystalline silicon can be formed. For example, the silicon ingot may be formed of at least 80% by volume mono-crystalline silicon of the same crystal orientation, and more preferably at least 95% mono-crystalline silicon of the same crystal orientation. This compares with ingots grown from a {100} plane in the prior art which are typically able to achieve 40% to 70% by volume mono-crystalline silicon. The improvement using the present invention is thus clear. Moreover, it should be born in mind that even where prior art techniques are able to achieve 70% by volume of mono-crystalline silicon, this still implies in practice that approximately 70% of wafers cut from that ingot include a mixture of multi- and mono-crystalline material, as the majority of wafers are typically cut from the edge of the ingot. This mixture of materials in the wafers of the prior art used with an alkaline texture etch limits the performance of the wafers and is highly negative to their visual appearance, both of which have negative effects on their commercial viability.

Following completion of the solidification of the material within the crucible 1, the temperature of the hot zone 2 is gradually reduced until the furnace can be opened and the solidified material is removed from the crucible 1.

Figures 4A and 4B show comparative views of typical silicon ingots 10 formed using seed layers in which growth has occurred normal to the {100} plane (Figure 4A) and normal to the {110} plane (Figure 4B). In each case, the silicon ingot comprises a mono-crystalline region 11 and a multi-crystalline region 12. The boundary of the mono-crystalline region forms an angle with the surface of the seed layer (i.e. with the horizontal) of θ. In the case of a seed layer exhibiting a {100} surface, the angle θ is found to be around 45-65 degrees (Figure 4A) whereas by using a seed layer having a {110} crystallographic surface, the angle θ is substantially 90 degrees (Figure 4B). As a result, the proportion of the mono-crystalline material formed using the {110} seed layer is significantly increased.

Once the silicon ingot 10 is formed, it is removed from the furnace and cut into silicon wafers. Prior to cutting the wafers, edges of the silicon ingot 10 are typically removed to avoid contamination from the crucible walls. Furthermore, a complete bottom section is removed at approximately the same height as the original sum of the heights of the silicon slab 7 and mono seed tiles 7. This bottom section can subsequently be trimmed down in size and reused as a replacement of the original slab 6 and tiles 7.

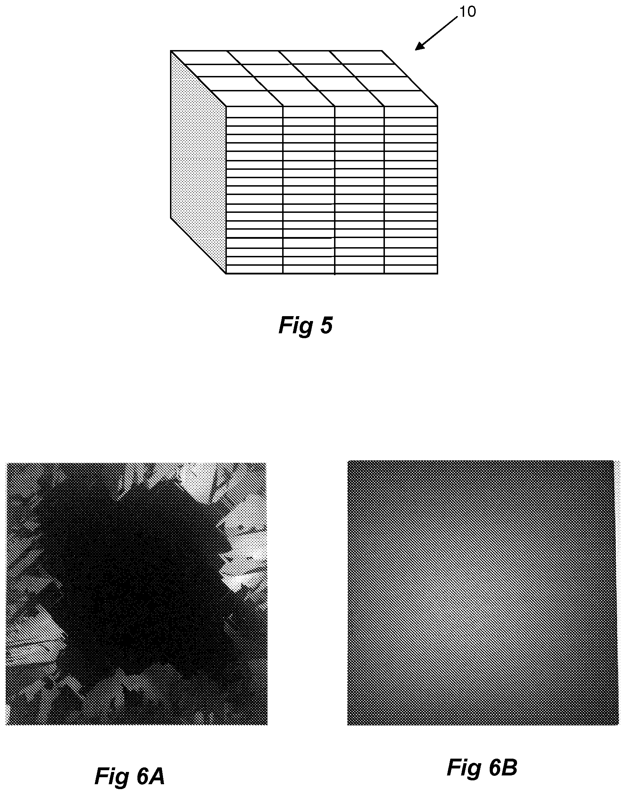

A silicon ingot 10 is illustrated in Figure 5. Figure 5 also shows the lines along which the ingot 10 may be cut to form silicon wafers. As can be seen, the silicon wafers are substantially planar and extend horizontally along the ingot 10. Accordingly, the silicon wafers are cut substantially parallel to the {110} plane. In this manner a significant number of silicon wafers can be cut from a single ingot 10. The wafers are preferably cut using a diamond wire cutting process. In this process, an array of parallel wires is used to saw the silicon ingot into a plurality of wafers. Diamond particles are attached to each wire in the saw and a solvent is typically used to carry silicon and heat away from the silicon ingot. A suitable process is described in international patent application WO 2011 /034439. The silicon ingot 10 of the preferred embodiment is particularly susceptible to the wire cutting processes because of the limited amount of multi-crystalline silicon in the ingot. This reduces the potential for impurities in the silicon ingot 10, which are typically introduced at the grain boundaries, defects and dislocations found in multi-crystalline silicon. In turn, this reduces the possibility of damage to the wires in a wire cutting process that can often occur as a result of such impurities, in particular when the wire encounters a relatively hard impurity, such as silicon carbide.

Once cut from the ingot, the wafers are normally washed, dried and inspected by a set of quality measurement tools. Thereafter, the {110} surface of the silicon wafers is etched to increase the surface area and thereby the light absorption efficiency of the wafer. In the preferred embodiment, this etching process is carried out by applying an isotropic etch to the wafers. The isotropic etch may comprise contacting the surface of the wafers with an acid, such as a mixture containing HF and HNO3. Other acids that may be used include H2SO4. In acid-based etching processes, the wafer is introduced to a bath containing the required acid solution, which causes the surface of the wafer to become textures as the acid reacts with the silicon surface. The texture is irregular, but is found to improve light absorption properties of the wafer.

Alternative etching processes may also be used to apply a texture to the surface of the silicon wafer. For example, in alternative embodiments, ion-etching or plasma-etching may be applied. In one example of such a process, nanoimprint lithography and subsequent plasma etching can be used to create a honeycomb structure on the surface of the silicon. An example of such a process is described in the paper by H. Hauser, A. Guttowski, J. Mick, M. Pfeifer, P. Voisin, M. Hermle, et al., published in the Proc. of the 24th European Photovoltaic Solar Energy Conf. and Exhibition, 2009, Hamburg, Germany.

The isotropic etching process provides a consistent response in regions of both mono-crystalline and multi-crystalline silicon. As a result, light absorption characteristics, including the visual appearance of the wafers, are consistent even if some regions of multi-crystalline silicon are present. These advantages can be clearly seen by comparison of Figures 6A and 6B. Figure 6A shows a wafer formed using a {100} seed layer after application of an anisotropic etching process and an anti-reflective coating (these being the two process that determine the visual appearance of the base material). In this case, there is a relatively large region of multi-crystalline silicon which is clearly visible in the ultimate cell. In contrast, Figure 6B shows a silicon wafer which has been formed using a {110} seed layer and subsequently etching the wafer using an isotropic etching process in accordance with the preferred embodiment. Using this technique, not only is the area of any multi-crystalline region significantly reduced but so is the visible distinction between this area and the mono-crystalline part of the wafer.

The above description presents a preferred embodiment of the present invention. However, the skilled person will recognise that various elements may be altered as appropriate. For example, the silicon ingot 10 may be cut across alternative angles in order to form wafers with different crystalline surfaces such as {100}. Moreover, anisotropic etching processes may potentially be used if appropriate.

## Claims

1. A method for producing crystalline silicon, the method comprising:
providing a silicon seed layer of uniform crystalline orientation in all axes in a crucible;
providing silicon feedstock above the seed layer;
melting the silicon feedstock and an upper part of the seed layer, thereby creating molten silicon within the crucible;
directionally solidifying the molten silicon to form a silicon ingot; wherein
the seed layer is arranged such that solidification of the molten silicon occurs in a direction normal to a {110} crystallographic plane of the seed layer.

2. A method according to claim 1, further comprising forming one or more silicon wafers from the silicon ingot.

3. A method according to claim 2, further comprising applying an isotropic etching step to a surface of the one or more silicon wafers.

4. A method according to claim 3, wherein the etching step comprises contacting the surface of the one or more silicon wafers with an acid.

5. A method according to claim 4, wherein the acid comprises one or both of HF and HNO3.

6. A method according to claim 3, wherein the etching step comprises ion-etching or plasma-etching.

7. A method according to any one of claims 2 to 6, wherein the step of forming the one or more wafers comprises a wire cutting process.

8. A method according to claim 7, wherein the wire cutting process is a diamond wire cutting process.

9. A method according to any one of the preceding claims, wherein an angle between the {110} crystallographic plane of the seed layer and a floor of the crucible is less than 15 degrees.

10. A method according to claim 9, wherein the angle between the {110} crystallographic plane of the seed layer and the floor of the crucible is less than 10 degrees.

11. A method according to claim 10, wherein the angle between the {110} crystallographic plane of the seed layer and the floor of the crucible is less than 5 degrees.

12. A method according to any one of the preceding claims, wherein the silicon ingot comprises a mono-crystalline region extending from the seed layer, an angle between outer edges of the mono-crystalline region and the seed layer being at least 80 degrees.

13. A method according to any one of the preceding claims, wherein at least 80% of the silicon ingot has a crystalline structure aligned with a crystalline structure of the seed layer.

14. A method according to any one of the preceding claims, wherein the seed layer comprises a plurality of seed tiles.

15. A method according to any one of the preceding claims, wherein the plurality of seed tiles are cut from a single mono-crystalline source.

16. A method according to claim 15, further comprising forming the mono-crystalline source by a Czochralski process.

17. A loaded crucible for use in the production of crystalline silicon by directional solidification, the loaded crucible comprising: a silicon seed layer of uniform crystalline alignment in all axes; and silicon feedstock disposed above the seed layer, wherein a {110} plane of a crystalline structure of the seed layer extends horizontally.

## Patentansprüche

1. Ein Verfahren zur Herstellung von kristallinem Silicium, wobei das Verfahren Folgendes umfasst:
Bereitstellen einer Silicium-Saatschicht von einheitlicher kristalliner Orientierung in allen Achsen in einem Schmelztiegel;
Bereitstellen von Silicium-Rohmaterial über der Saatschicht;
Schmelzen des Silicium-Rohmaterials und eines oberen Teils der Saatschicht, wodurch geschmolzenes Silicium im Schmelztiegel entsteht;
direktionales Erstarren des geschmolzenen Siliciums, um einen Silicium-Barren zu bilden; wobei die Saatschicht so angeordnet ist, dass das Erstarren des geschmolzenen Siliciums in einer Richtung normal zur einer {110} kristallografischen Ebene der Saatschicht erfolgt.

2. Ein Verfahren entsprechend Anspruch 1, zudem außerdem gehört, dass vom Silicium-Barren eine oder mehrere Silicium-Scheiben gebildet wird/werden.

3. Ein Verfahren entsprechend Anspruch 2, zu dem zudem der Schritt des isotropen Ätzens einer Oberfläche der einen oder mehreren Silicium-Scheiben gehört.

4. Ein Verfahren entsprechend Anspruch 3, wobei der Schritt des Ätzens das Kontaktieren einer Oberfläche der einen oder mehreren Silicium-Scheiben umfasst.

5. Ein Verfahren entsprechend Anspruch 4, wobei die Säure entweder HF oder HNO3 oder beide umfasst.

6. Ein Verfahren entsprechend Anspruch 3, wobei der Schritt des Ätzens Ionenätzen oder Plasmaätzen umfasst.

7. Ein Verfahren entsprechend einem der Ansprüche 2 bis 6, der Schritt des Bildens einer oder mehreren Scheiben einen Drahtschneidprozess umfasst.

8. Ein Verfahren entsprechend Anspruch 7, wobei der Drahtschneidprozess ein Diamantdrahtschneidprozess ist.

9. Ein Verfahren entsprechend einem der vorhergehenden Ansprüche, wobei der Winkel zwischen der {110} kristallografischen Ebene der Saatschicht und dem Boden des Schmerztiegels weniger als 15 Grad beträgt.

10. Ein Verfahren entsprechend Anspruch 9, wobei der Winkel zwischen der {110} kristallografischen Ebene der Saatschicht und dem Boden des Schmerztiegels weniger als 10 Grad beträgt.

11. Ein Verfahren entsprechend Anspruch 10, wobei der Winkel zwischen der {110} kristallografischen Ebene der Saatschicht und dem Boden des Schmerztiegels weniger als 5 Grad beträgt.

12. Ein Verfahren entsprechend einem der vorhergehenden Ansprüche, wobei der Silicium-Barren einen monokristallinen Bereich umfasst, der von der Saatschicht verläuft, wobei ein Winkel zwischen den Außenkanten des monokristallinen Bereichs und der Saatschicht mindestens 80 Grad beträgt.

13. Ein Verfahren entsprechend einem der vorhergehenden Ansprüche, bei dem mindestens 80% des Silicium-Barrens eine kristalline Struktur aufweist, die auf die kristalline Struktur der Saatschicht ausgerichtet ist.

14. Ein Verfahren entsprechend einem der vorhergehenden Ansprüche, wobei die Saatschicht eine Vielzahl an Saatplatten umfasst.

15. Ein Verfahren entsprechend einem der vorhergehenden Ansprüche, wobei die Vielzahl an Saatplatten von einer einzelnen monokristallinen Quelle geschnitten werden.

16. Ein Verfahren entsprechend Anspruch 15, das zudem das Erstellen der monokristallinen Quelle durch ein Czochralski-Verfahren umfasst.

17. Ein beladener Schmelztiegel zur Verwendung bei der Herstellung von kristallinem Silicium durch direktionales Erstarren, wobei der beladene Schmelztiegel Folgendes umfasst: eine Silicium-Saatschicht mit einheitlicher kristalliner Ausrichtung in allen Achsen; und Silicium-Rohmaterial, das über der Saatschicht angeordnet ist, wobei eine {110} Ebene einer kristallinen Struktur der Saatschicht horizontal verläuft.

## Revendications

1. Procédé de production de silicone cristallin, le procédé consistant à :
réaliser une couche de germe de silicium ayant une orientation cristalline uniforme dans tous les axes dans un creuset ;
fournir une charge de silicium au-dessus de la couche de germe ;
fondre la charge de silicium et une partie supérieure de la couche de germe, ce qui permet de créer du silicium fondu dans le creuset ;
solidifier directionnellement le silicium fondu pour former un lingot de silicium ; dans
lequel la couche de silicium est agencée de manière à ce qu'une solidification du silicium fondu se produise dans une direction normale à un plan cristallographique {110} de la couche de germe.

2. Procédé selon la revendication 1, comprenant en outre la formation d'une ou plusieurs tranches de silicium à partir du lingot de silicium.

3. Procédé selon la revendication 2, consistant en outre à appliquer une étape de gravure isotrope à une surface de la ou des tranches de silicium.

4. Procédé selon la revendication 3, dans lequel l'étape de gravure consiste à mettre en contact la surface d'une ou plusieurs des tranches de silicium avec un acide.

5. Procédé selon la revendication 4, dans lequel l'acide comprend le HF et/ou le HN03.

6. Procédé selon la revendication 3, dans lequel l'étape de gravure comprend une gravure ionique ou une gravure au plasma.

7. Procédé selon l'une quelconque des revendications 2 à 6, dans lequel l'étape de formation d'une ou plusieurs de ces tranches comprend un processus de coupe par fil.

8. Procédé selon la revendication 7, dans lequel le processus de coupe par fil est un processus de coupe par fil au diamant.

9. Procédé selon l'une quelconque des revendications précédentes, dans lequel un angle entre le plan cristallographique {110} de la couche de germe et un fond du creuset est inférieur à 15 degrés.

10. Procédé selon la revendication 9, dans lequel un angle entre le plan cristallographique {110} de la couche de germe et un fond du creuset est inférieur à 10 degrés.

11. Procédé selon la revendication 10, dans lequel un angle entre le plan cristallographique {110} de la couche de germe et un fond du creuset est inférieur à 5 degrés.

12. Procédé selon l'une quelconque des revendications précédentes, dans lequel le lingot de silicium comprend une zone monocristalline qui se prolonge de la couche de germe, un angle entre les bords externes de la zone monocristalline et la couche de germe étant à au moins 80 degrés.

13. Procédé selon l'une quelconque des revendications précédentes, dans lequel au moins 80 % du lingot de silicium possède une structure cristalline alignée sur une structure cristalline de la couche de germe.

14. Procédé selon l'une quelconque des revendications précédentes, dans lequel la couche de germe comprend une pluralité de dalles de germes.

15. Procédé selon l'une quelconque des revendications précédentes, dans lequel la pluralité de dalles de germe sont découpées à partir d'une simple source monocristalline.

16. Procédé selon la revendication 15, comprenant en outre la formation de la source monocristalline par une méthode Czochralski.

17. Creuset chargé servant à la production de silicium cristallin par solidification directionnelle, le creuset chargé comprenant : une couche de germe de silicium ayant un alignement cristallin uniforme dans tous les axes ; et une charge de silicium disposée au-dessus de la couche de germe, dans lequel un plan {110} de structure cristalline de la couche de germe se prolonge à l'horizontale.
